# EUROPEAN PATENT APPLICATION

(11) **EP 1 746 181 A2**
(43) Date of publication of application: **24.01.2007**
(21) Application number: 05027110.5
(22) Date of filing: 12.12.2005
(51) Int. Cl.: C23C 14/35, H01J 37/34

(54) **Improved magnetron sputtering system for large-area substrates**

(30) Priority: 13.07.2005 US 182034
(71) Applicant: APPLIED MATERIALS, INC., Santa Clara, California 95054 (US)
(72) Inventor: White, John, Hayward, CA 94541 (US); Hosokawa, Akihiro, Cupertino, CA 95014 (US); Le, Hienminh H., San Jose, CA 95148 (US); Inagawa, MAkoto, Palo Alto, CA 94306 (US)
(74) Representative: Zimmermann, Gerd Heinrich

(57) **Abstract**

The present invention generally provides an apparatus and method for processing a surface of a substrate (12) in physical vapor deposition (PVD) chamber (1) that has an increased anode surface area to improve the deposition uniformity on large area substrates (12). In general, aspects of the present invention can be used for flat panel display processing, semiconductor processing, solar cell processing, or any other substrate processing. In one aspect, the processing chamber contains one or more adjustable anode assemblies (90; 90A; 90B) that are used to increase and more evenly distribute the anode surface area throughout the processing region (15) of the processing chamber. In one aspect, the one or more adjustable anode assemblies are adapted to exchange deposited on anode surfaces with new, un-deposited on, anode surfaces without breaking vacuum. In another aspect, a shadow frame (52) that has a path to ground is adapted to contact a deposited layer on the surface of a substrate during deposition to increase the anode area and thus deposition uniformity.

## Description

### BACKGROUND OF THE INVENTION

Embodiments of the present invention generally relate to substrate plasma processing apparatuses and methods that are adapted to deposit a film on a surface of a substrate.

Physical vapor deposition (PVD) using a magnetron is one of the principal methods of depositing metal onto a semiconductor integrated circuit to form electrical connections and other structures in an integrated circuit device. During a PVD process a target is electrically biased so that ions generated in a process region can bombard the target surface with sufficient energy to dislodged atoms from the target. The process of biasing a target to cause the generation of a plasma that causes ions to bombard and remove atoms from the target surface is commonly called sputtering. The sputtered atoms travel generally ballistically toward the wafer being sputter coated, and the sputtered atoms are deposited on the wafer. Alternatively, the atoms react with another gas in the plasma, for example, nitrogen, to reactively deposit a compound on the wafer. Reactive sputtering is often used to form thin barrier and nucleation layers of titanium nitride or tantalum nitride on the sides of narrow holes.

DC magnetron sputtering is the most usually practiced commercial form of sputtering. The metallic target is biased to a negative DC bias in the range of about -400 to -600 VDC to attract positive ions of the working gas (e.g., argon) toward the target to sputter the metal atoms. Usually, the sides of the sputter reactor are covered with a shield to protect the chamber walls from sputter deposition. The shield is typically electrically grounded and thus provides an anode in opposition to the target cathode to capacitively couple the DC target power into the chamber and its plasma.

A magnetron having at least a pair of opposed magnetic poles is typically disposed near the back of the target to generate a magnetic field close to and parallel to the front face of the target. The induced magnetic field from the pair of opposing magnets trap electrons and extend the electron lifetime before they are lost to an anodic surface or recombine with gas atoms in the plasma. Due to the extended lifetime, and the need to maintain charge neutrality in the plasma, additional argon ions are attracted into the region adjacent to the magnetron to form there a high-density plasma. Thereby, the sputtering rate is increased.

However, conventional sputtering presents challenges in the formation of advanced integrated circuits on large area substrates, such a flat panel display substrates. Typically, for TFT applications, the substrate is a glass substrate with a surface area greater than about 2000 cm². Commonly, TFT processing equipment is generally configured to accommodate substrates up to about 1.5 x 1.8 meters. However, processing equipment configured to accommodate substrate sizes up to and exceeding 2.16 x 2.46 meters, is envisioned in the immediate future. One issue that arises is that it is generally not feasible to create a chamber big enough to maintain the surface area ratio of the cathode (target) to anode surface area commonly used in conventional sputter processing chambers. Trying to maintain the surface area ratio can lead to manufacturing difficulties due to the large size of the parts required to achieve the desired area ratio and processing problems related to the need to pump down such a large volume to a desired base pressure prior to processing. The reduced surface area of the anode relative to the large target surface area generally causes the density of the plasma generated in the processing region, which is generally defined as the region below the target and above the substrate, to vary significantly from the center of the target to the edge of the target. Since the anodic surfaces are commonly distributed around the periphery of the target, it is believed that the larger distance from the center of the target to the anodic surfaces, makes the emission of electrons from the target surface at the edge of the target more favorable, and thus reduces the plasma density near the center of the target. The reduction in plasma density in various regions across the target face will reduce the number of ions striking the surface of the target in that localized area and thus varying the uniformity of the deposited film across the surface of a substrate that is positioned a distance from the target face. The insufficient anode area problem will thus manifest itself as a film thickness non-uniformity that is smaller near the center of the substrate relative to the edge.

To resolve the insufficient anode area problem some individuals have installed additional anode structures that are positioned in the processing region below the target to increase the anode surface area. Installed anode structures commonly include a fixed-anode structure (e.g., collimator) or a scanning anode structure that is position below the target face, which is aligned with and moves with the moving magnetron structure as it is translated during the deposition process. One issue with the anode structure(s) retained, or installed, in the processing region is that over time they are continually deposited on during processing, thus causing their size and shape of the structures to vary with time. Since PVD type processes are typically line of sight type deposition processes the variation in their size and shape of the structures over time will cause the deposition uniformity to change over time. Also, the deposition of the target material on the structures also increases the probability that the material deposited thereon will crack and flake during processing, due to intrinsic or extrinsic stress formed in the films deposited on these structures. Cracking and flaking of the deposited film can generate particles that can effect the yield of the devices formed using this process.

Therefore, there is a need for a method and apparatus that can form a more uniform plasma in a PVD processing chamber that will not generate particles and can overcome the other drawbacks described above.

### SUMMARY OF THE INVENTION

This and related problems are solved by the plasma processing chamber assembly according to the claims 1, 8 and 12, and the methods according to the claims 16, 17 and 19. Preferred embodiments, improvements and further details of the invention are disclosed in the dependent claims, the description and the figures.

The present invention generally provides a plasma processing chamber assembly for depositing a layer on a substrate comprising a plasma processing chamber having a processing region, a target positioned on the plasma processing chamber so that a surface of the target is in contact with the processing region, an anodic shield positioned inside the plasma processing chamber, wherein a surface of the anodic shield is in contact with the processing region, a substrate support positioned inside the plasma processing chamber and having a substrate receiving surface, wherein a surface of a substrate positioned on the substrate receiving surface is in contact with the processing region and a second anodic member having a first surface positioned inside the processing region and a second surface positioned outside the processing region, wherein the first surface can be removed from the processing region and the second surface can be positioned inside the processing region by use of an actuator.

Embodiments of the invention may further provide a plasma processing chamber assembly for depositing a layer on a substrate comprising a plasma processing chamber having a processing region; a target positioned on the plasma processing chamber so that a surface of the target is in contact with the processing region; an anodic shield positioned inside the plasma processing chamber, wherein the anodic shield comprises: one or more walls that surround the processing region; a first slot formed through the one of the one or more walls; and a second slot formed through the one of the one or more walls; a substrate support positioned inside the plasma processing chamber and having a substrate receiving surface, wherein a surface of a substrate positioned on the substrate receiving surface is in contact with the processing region; and one or more adjustable anode assemblies that comprise: a second anodic member extending through the first slot and the second slot and having a surface that is in contact with the processing region; a feed roller assembly positioned outside of the processing region and connected to the second anodic member; and a take-up roller assembly positioned outside of the processing region and connected to the second anodic member, wherein the feed roller assembly and the take-up roller assembly are adapted to cooperatively adjust the position of the surface of the second anodic member in the processing region.

Embodiments of the invention may further provide a plasma processing chamber assembly for depositing a layer on a substrate comprising: a plasma processing chamber having a processing region, a target positioned on the plasma processing chamber so that a surface of the target is in contact with the processing region, an anodic shield positioned inside the plasma processing chamber, wherein a surface of the anodic shield is in contact with the processing region, a substrate support having a substrate receiving surface positioned inside the plasma processing chamber, wherein a substrate positioned on the substrate receiving surface is in contact with the processing region and a shadow frame having a surface that is in contact with the processing region and having a conductive feature that is in electrical communication with an anodic shield, wherein the conductive feature is adapted to contact a metal layer formed on a substrate that is positioned on the substrate receiving surface.

Embodiments of the invention may further provide a method for depositing a thin film on a substrate, comprising placing a substrate on a substrate support that is mounted in a processing region of a processing chamber, positioning a substrate in a first processing position in the processing region of a plasma processing chamber, depositing a layer onto a surface of the substrate positioned on the substrate support, positioning a substrate in a second processing position in the processing region of a plasma processing chamber, wherein positioning a substrate in a second processing position causes a shadow frame that is electrically grounded is placed in electrical contact with the layer deposited on the substrate surface and depositing a layer onto a surface of the substrate positioned on the substrate support.
Note that, preferably, the first anodic member is an anodic shield.
Further, the present invention also relates to an apparatus and method for processing a surface of a substrate in physical vapor deposition (PVD) chamber that has an increased anode surface area to improve the deposition uniformity on large area substrates. In general, aspects of the present invention can be used for flat panel display processing, semiconductor processing, solar cell processing, or any other substrate processing. In one aspect, the processing chamber contains one or more adjustable anode assemblies that are used to increase and more evenly distribute the anode surface area throughout the processing region of the processing chamber. In one aspect, the one or more adjustable anode assemblies are adapted to exchange deposited on anode surfaces with new, un-deposited on, anode surfaces without breaking vacuum. In another aspect, a shadow frame that has a path to ground is adapted to contact a deposited layer on the surface of a substrate during deposition to increase the anode area and thus deposition uniformity

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figure 1 is a vertical cross-sectional view of conventional physical vapor deposition chamber.

Figure 2A is a vertical cross-sectional view of an exemplary physical vapor deposition chamber.

Figure 3A is a vertical cross-sectional view of a processing region formed in an exemplary physical vapor deposition chamber.

Figure 3B is a vertical cross-sectional view of a processing region formed in an exemplary physical vapor deposition chamber.

Figure 3C is a vertical cross-sectional view of a processing region formed in an exemplary physical vapor deposition chamber.

Figure 3D is a vertical cross-sectional view of a processing region formed in an exemplary physical vapor deposition chamber.

Figure 4A is a horizontal cross-sectional view of a processing region formed in an exemplary physical vapor deposition chamber.

Figure 4B is a horizontal cross-sectional view of a processing region formed in an exemplary physical vapor deposition chamber.

Figure 4C is a horizontal cross-sectional view of a processing region formed in an exemplary physical vapor deposition chamber.

Figure 4D is a horizontal cross-sectional view of a motion assembly shown in Figures 4A-C, which may useful to perform aspects of the invention disclosed herein.

Figure 5A is a vertical cross-sectional view of a target and magnetron assemblies that may be used in an exemplary physical vapor deposition chamber.

Figure 5B is a vertical cross-sectional view of an exemplary physical vapor deposition chamber.

Figure 6A s a vertical cross-sectional view of a processing region formed in an exemplary physical vapor deposition chamber.

Figure 6B is a vertical cross-sectional view of an exemplary physical vapor deposition chamber.

Figure 6C is a vertical cross-sectional view of an exemplary physical vapor deposition chamber.

Figure 6D is a flow chart of method steps for depositing a uniform layer on a substrate, in accordance with various embodiments of the invention.

Figure 6E is a flow chart of method steps for depositing a uniform layer on a substrate, in accordance with various embodiments of the invention.

Figure 6F is a isometric cross-sectional view of the processing region of an exemplary physical vapor deposition chamber.

Figure 6G s a vertical cross-sectional view of a processing region formed in an exemplary physical vapor deposition chamber.

### DETAILED DESCRIPTION

The present invention generally provides an apparatus and method for processing a surface of a substrate in PVD chamber that has an increased anode surface area to improve the deposition uniformity. In general, aspects of the present invention can be used for flat panel display processing, semiconductor processing, solar cell processing, or any other substrate processing. The invention is illustratively described below in reference to a physical vapor deposition system, for processing large area substrates, such as a PVD system, available from AKT, a division of Applied Materials, Inc., Santa Clara, California. In one embodiment, the processing chamber is adapted to process substrates that have a surface area of at least about 2000 cm². In another embodiment, the processing chamber is adapted to process substrates that have a surface area of at least about 19,500 cm² (e.g., 1300 mm x 1500 mm). However, it should be understood that the apparatus and method may have utility in other system configurations, including those systems configured to process large area round substrates.

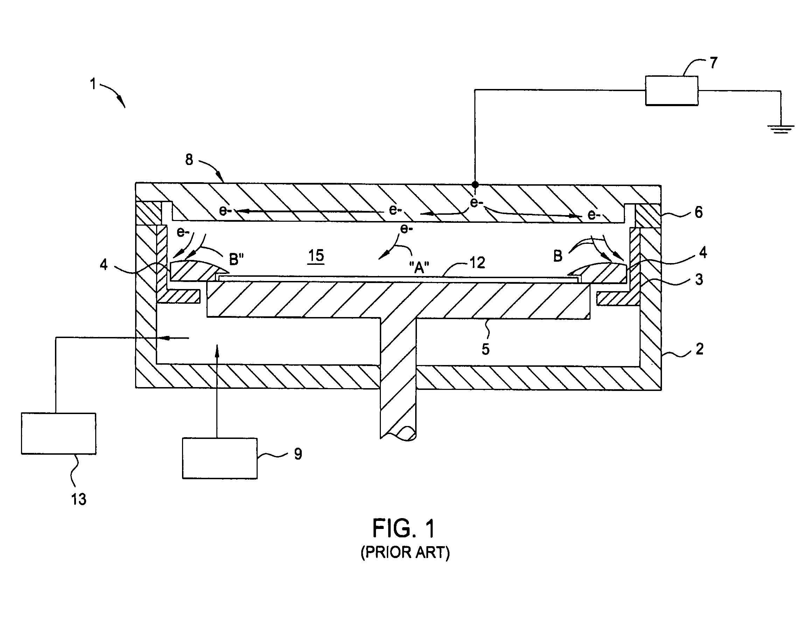

Figure 1 illustrates a cross-sectional view of the processing region of a conventional physical vapor deposition (PVD) chamber 1. The conventional PVD chamber 1 generally contains a target 8, a vacuum chamber 2, a grounded shield 3, a shadow ring 4, an target electrical insulator 6, a DC power supply 7, a process gas source 9, a vacuum pump system 13 and a substrate support 5. To perform a sputtering process, a process gas, such as argon, is delivered into the evacuated conventional PVD chamber 1 from the gas source 9 and a plasma is generated in the processing region 15 due to a negative bias created between the target 8 and the grounded shield 3 by use of the DC power supply 7. In general, the plasma is primarily generated and sustained by the emission of electrons from the surface of the target due to the target bias and secondary emission caused by the ion bombardment of the negative (cathodic) target surface. Prior to performing the PVD processing step(s) it is common for the vacuum chamber 2 to be pumped down to a base pressure (e.g., 10⁻⁶ to 10⁻⁹ Torr) by use of the vacuum pump system 11.

Figure 1 is intended to illustrate one of the causes of the plasma non-uniformity in a large area substrate processing chamber by highlighting the path difference between the an electron (see e⁻) ejected from the surface of the target 1 near the center of the target (see path "A") and electrons emitted from the surface of the target near the edge (see path "B"). While the longer path to ground experienced by an electron leaving the center of the target may increase the number of collisions the electron will undergo before it is lost to the anode surface or recombined with an ion contained in the plasma, the bulk of the electrons emitted from the target 8 will be emitted near the edge of the target due to the reduced electrical resistance of this path to ground. The reduced electrical resistance of the path near the edge of the target to ground is due to the lower resistance path through the conductive target 8 material(s) and the shorter path length ("B") of the electron's path to ground. The lower resistance path thus tends to increase the current density and plasma density near the edge of the target thus increasing the amount of material sputtered at the edge versus the center of the target 1.

### Increased Anode Area Hardware

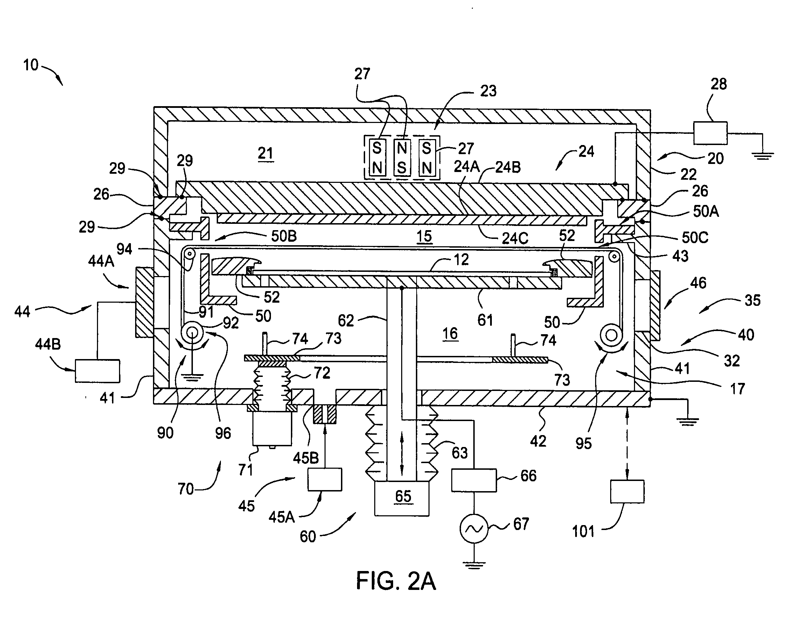

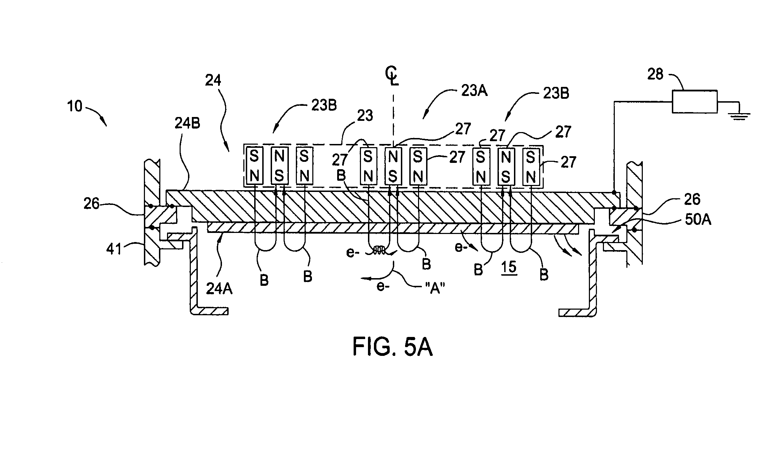

Figure 2A illustrates a vertical cross-sectional view of one embodiment of a processing chamber 10 that may be used to perform aspects of the invention described herein. In the configuration illustrated in Figure 2A, the processing chamber 10 contains one or more adjustable anode assemblies 90 that are used to increase and more evenly distribute the anode surface area throughout the processing region 15. Figure 2A illustrates a substrate 12 that is positioned in a processing position in the processing region 15. In general, the processing chamber 10 contains a lid assembly 20 and a lower chamber assembly 35. The lid assembly 20 generally contains a target 24, a lid enclosure 22, a ceramic insulator 26, one or more o-ring seals 29 and one or more magnetron assemblies 23 that are positioned in a target backside region 21. Generally, each magnetron assembly 23 will have at least one magnet 27 that has a pair of opposing magnetic poles (i.e., north (N) and south (S)) that create a magnetic field (B-field) that passes through the target 24 and the processing region 15 (see element "B" in Figure 5A). Figure 2A illustrates a cross-section of one embodiment of a processing chamber 10 that has one magnetron assembly 23 that contain three magnets 27, which are positioned at the back of the target 24. It should be noted that while the target 24, illustrated in Figure 2A, has a backing plate 24B and target material 24A other embodiments of the invention may use a solid, or monolithic, type target without varying from the basic scope of the invention. An exemplary magnetron assembly, that may be adapted to benefit the invention described herein is further described in the commonly assigned United States Patent Application serial number 10/863,152 [AMAT 8841], filed June 7th, 2004, which claims the benefit of United States Provisional Patent Application serial number 60/534,952, filed January 7th, 2004, and is hereby incorporated by reference in its entirety to the extent not inconsistent with the claimed invention.

The lower chamber assembly 35 generally contains a substrate support assembly 60, chamber body assembly 40, a shield 50 (first anodic member), a process gas delivery system 45 and a shadow frame 52. The shadow frame 52 is generally used to shadow the edge of the substrate to prevent or minimize the amount of deposition on the edge of a substrate 12 and substrate support 61 during processing (see Figure 2A). The chamber body assembly 40 generally contains one or more chamber walls 41 and a chamber base 42. The one or more chamber walls 41, the chamber base 42 and target 24 generally form a vacuum processing area 17 that has a lower vacuum region 16 and a processing region 15. In one aspect, a shield mounting surface 50A of the shield 50 is mounted on or connected to a grounded chamber shield support 43 formed in the chamber walls 41 to ground the shield 50. The process gas delivery system 45 generally contains one or more gas sources 45A that are in fluid communication with one or more inlet ports 45B that are in direct communication with the lower vacuum region 16 (shown in Figure 2A) and/or the processing region 15, to deliver a process gas that can be used during the plasma process. Typically, the process gas used in PVD type applications is, for example, an inert gas such as argon, but other gases such as nitrogen may be used.

The substrate support assembly 60 generally contains a substrate support 61, a shaft 62 that is adapted to support the substrate support 61, and a bellows 63 that is sealably connected to the shaft 62 and the chamber base 42 to form a moveable vacuum seal that allows the substrate support 61 to be positioned in the lower chamber assembly 35 by the lift mechanism 65. The lift mechanism 65 may contain a conventional linear slide (not shown), pneumatic air cylinder (not shown) and/or DC servo motor that is attached to a lead screw (not shown), which are adapted to position the substrate support 61, and substrate 12, in a desired position in the processing region 15.

Referring to Figure 2A, the lower chamber assembly 35 will also generally contain a substrate lift assembly 70, slit valve 46 and vacuum pumping system 44. The lift assembly 70 generally contains three or more lift pins 74, a lift plate 73, a lift actuator 71, and a bellows 72 that is sealably connected to the lift actuator 71 and the chamber base 42 so that the lift pins 74 can remove and replace a substrate positioned on a robot blade (not shown) that has been extended into the lower chamber assembly 35 from a central transfer chamber (not shown). The extended robot blade enters the lower chamber assembly 35 through the access port 32 in the chamber wall 41 and is positioned above the substrate support 61 that is positioned in a transfer position (not shown). The vacuum pumping system 44 (elements 44A and 44B) may generally contains a cryo-pump, turbo pump, cryo-turbo pump, rough pump, and/or roots blower to evacuate the lower vacuum region 16 and processing region 15 to a desired base and/or processing pressure. A slit valve actuator (not shown) which is adapted to position the slit valve 46 against or away from the one or more chamber walls 41 may be a conventional pneumatic actuator which are well known in the art.

To control the various processing chamber 10 components and process variables during a deposition process, a controller 101 is used. The processing chamber's processing variables may be controlled by use of the controller 101, which is typically a microprocessor-based controller. The controller 101 is configured to receive inputs from a user and/or various sensors in the plasma processing chamber and appropriately control the plasma processing chamber components in accordance with the various inputs and software instructions retained in the controller's memory. The controller 101 generally contains memory and a CPU which are utilized by the controller to retain various programs, process the programs, and execute the programs when necessary. The memory is connected to the CPU, and may be one or more of a readily available memory, such as random access memory (RAM), read only memory (ROM), floppy disk, hard disk, or any other form of digital storage, local or remote. Software instructions and data can be coded and stored within the memory for instructing the CPU. The support circuits are also connected to the CPU for supporting the processor in a conventional manner. The support circuits may include cache, power supplies, clock circuits, input/output circuitry, subsystems, and the like all well known in the art. A program (or computer instructions) readable by the controller 101 determines which tasks are performable in the plasma processing chamber. Preferably, the program is software readable by the controller 101 and includes instructions to monitor and control the plasma process based on defined rules and input data.

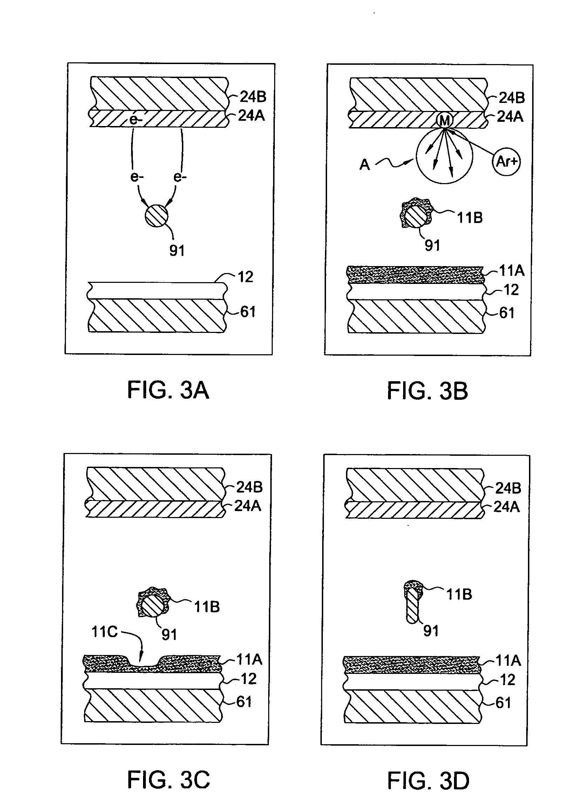

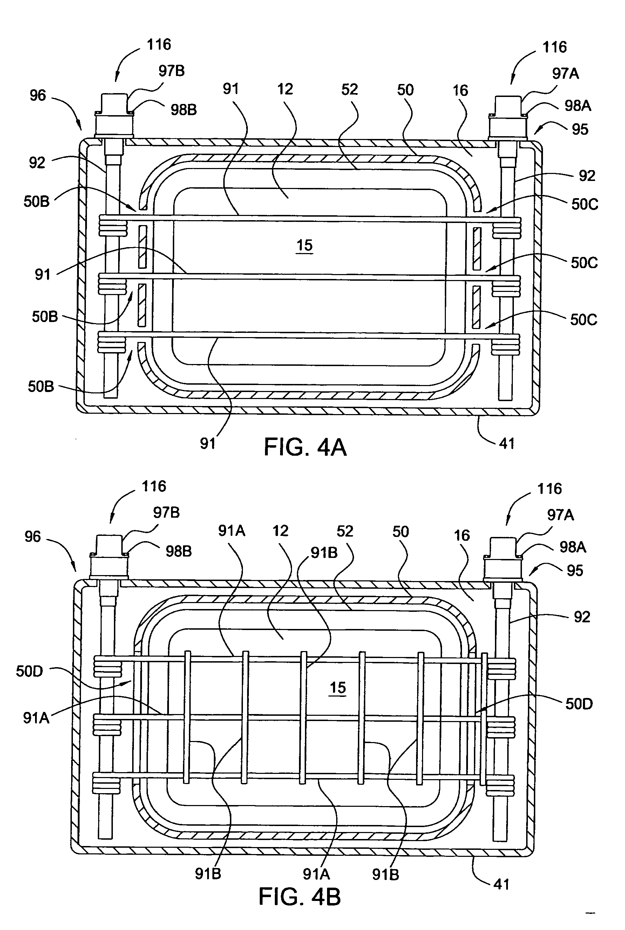

Figure 2A also illustrates one embodiment of the one or more adjustable anode assemblies 90, which are positioned in the lower chamber assembly 35. In general, the adjustable anode assembly 90 (second anode member) has a conductive member 91 that extends through the processing region 15 and is grounded so that plasma generated in the processing region 15 is more uniform due to the more even distribution of the anode surfaces relative to all areas of the target surface 24C. In one aspect, the conductive member 91 may be a wire, multi-stranded cable, metal ribbon, sheet, or wire mesh that is made of conductive metal such as, for example, titanium, aluminum, platinum, copper, magnesium, chrome, manganese, stainless steel, hastelloy C, nickel, tungsten, tantalum, iridium, ruthenium and alloys and/or combination thereof. Generally, the conductive member 91 needs to be sized and made from a material that is conductive enough to receive a significant portion of the generated current when the target is biased, while also being made from a material that has a high enough melting point and is strong enough to not appreciably deform under the weight of the deposited material at the high temperatures that will be seen during processing. The high temperatures will likely be created by radiative type heat transfer and IR drop heating from the flow of current through the conductive member 91. Examples of some various embodiments of the conductive member 91 are illustrated in conjunction with Figures 3A-D and 4A-B, which are discussed below.

To perform a PVD deposition process, the controller 101 commands the vacuum pumping system 44 to evacuate the processing chamber 10 to a predetermined pressure/vacuum so that the plasma processing chamber 10 can receive a substrate 12 from a system robot (not shown) mounted to a central transfer chamber (not shown) which is also under vacuum. To transfer a substrate 12 to the processing chamber 10 the slit valve (element 46), which seals off the processing chamber 10 from the central transfer chamber, opens to allow the system robot to extend through the access port 32 in the chamber wall 41. The lift pins 74 then remove the substrate 12 from the extended system robot, by lifting the substrate from the extended robot blade (not shown). The system robot then retracts from the processing chamber 10 and the slit valve 46 closes to isolate the processing chamber 10 from the central transfer chamber. The substrate support 61 then lifts the substrate 12 from the lift pins 74 and moves the substrate 12 to a desired processing position below the target 24. Then after a achieving a desired base pressure, a desired flow of a processing gas is injected into the processing region 15 and a bias voltage is applied to the target 24 by use of a power supply 28 to generate a plasma in the processing region 15. The application of a DC bias voltage by the power supply 28 causes the gas ionized in the processing region 15 to bombard the target surface and thus "sputter" metal atoms that land on the surface of the substrate positioned on the surface of the substrate support 61. In the configuration shown in Figure 2A, a percentage of the generated current from the application of the bias voltage will pass through the grounded conductive member 91 and thus allow the generated plasma to be more uniformly distributed throughout the processing region. It should be noted that the term "grounded" is generally intended to describe a direct or in-direct electrical connection between the conductive member 91 to the anode surfaces positioned inside the process chamber. In one aspect, the conductive member 91 may be purposely biased at a different potential versus the anode surfaces by the introduction of a resistive, capacitive and/or inductive components to the electrical path between the conductive surfaces 91 and the anode surfaces. Figure 3A illustrates a vertical cross-sectional view of the processing region 15 and conductive member 91, that is intended to conceptually illustrate the current flow path from the target to the grounded conductive member 91. One advantage of the adjustable anode assemblies 90 embodiments described herein is the fact that they tend to reduce the required target bias voltage to achieve a desired deposition rate, because of the reduced resistance of the path to ground.

Figures 3B illustrates a vertical cross-sectional view of the processing region 15 showing the target 24 (elements 24A and 24B), conductive member 91 and the substrate 12 positioned on a substrate support 61. Figure 3B is intended to illustrate the effect of an ionized gas atom, here an argon atom, striking the target surface 24C of the target material 24A where a target atom (element "M") is sputtered from the surface in any direction and forms a film 11A on the substrate 12 positioned on the substrate support 61. In general the "sputtered" target atoms (element "M") leave the target surface non-directional manner (see arrows "A") and thus the sputtered target atoms (element M) will be deposited on the substrate surface, thus forming the film 11A thereon, and a film 11 B on the conductive member 91. During processing and idle times, the temperature of the conductive member 91 will vary greatly thus possibly causing the film 11 B deposited on the conductive member 91 to vary the shape of the conductive member 91 or cause the deposited material to flake and generate particles which can cause device yield problems on the processed substrate(s). In one aspect, to resolve this issue the surface of the conductive member 91 may be roughened by grit blasting, chemical etching or other conventional techniques to increase the mechanical adhesion of the deposited film to the conductive member 91. In one aspect, an aluminum arc spray, flame spray or plasma spray coating may be deposited on the surface of the conductive member 91 to improve the adhesion of the deposited film.

In another aspect, the adjustable anode assembly 90 is adapted to exchange portions of the conductive member 91 that have been deposited on in the processing region 15 with new, or un-deposited on, conductive member 91 surfaces. This configuration can help to minimize or eliminate the deposition uniformity and particle problems issues caused by the deposited material coating the anode surface(s). The ability to reposition the conductive member 91 will reduce the chamber downtime, caused by the need to replace the anode surfaces that are placed in the processing region, which can be very time consuming and costly. A significant part of the chamber down time found in conventional processing chambers is incurred by the completion of the following tasks: waiting for the process chamber components cool to a temperature where they can be handled, venting the chamber and breaking vacuum, removing the used anode surfaces, installing a new anode components, closing the chamber, pumping down the and baking out the chamber, and then preparing the process chamber for processing. Therefore, the embodiments described herein do not require the performance of these tasks every time an anode surface has to be replaced, which saves time and expense.

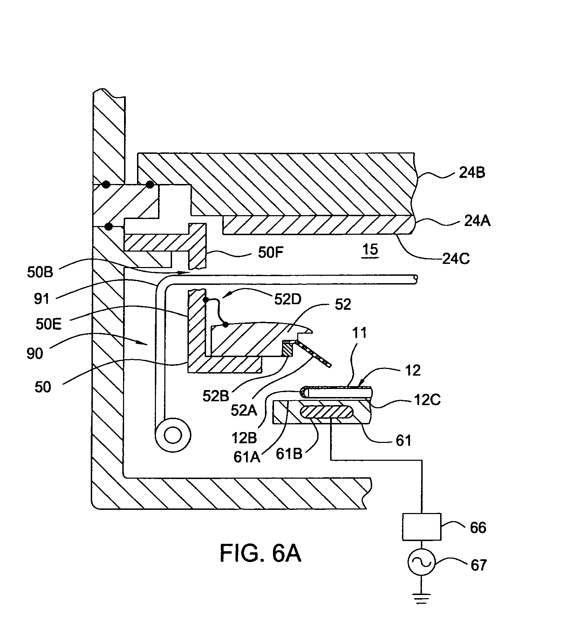

In one aspect, to perform the process repositioning of the exposed conductive member 91 surfaces, the adjustable anode assembly 90 may contain a feed roller assembly 96, a take-up roller assembly 95, and a conductive member 91 connected to the feed roller assembly 96 and take-up roller assembly 95. Generally, the conductive member 91 is thus fed from the feed roller assembly 96 through a first slot 50B formed in the shield 50, then through the processing region 15 and a second slot 50C formed in the shield 50, where it is collected by the take-up roller assembly 95. Referring to Figure 6A, generally, the term slot (e.g., element 50B) used herein is intended to describe a slit, narrow opening, perforation, gap or hole that connects one surface (element 50E) of the shield to another surface (element 50F) of the shield. In another aspect, as shown in Figure 2A, two alignment rollers 94 are positioned between the feed roller assembly 96 and the first slot 50B, and the second slot 50C and the take-up roller assembly 95 to support and orient the conductive member 91 as it passes through the processing region 15. In this configuration as the conductive member 91 is deposited on during processing, the controller 101 adjusts the rotational position of the take-up roller assembly 95 and/or the feed roller assembly 96 to cause an amount of the undeposited on conductive member 91 to move into the processing region 15 and the deposited on conductive member 91 regions to move out of the processing region.

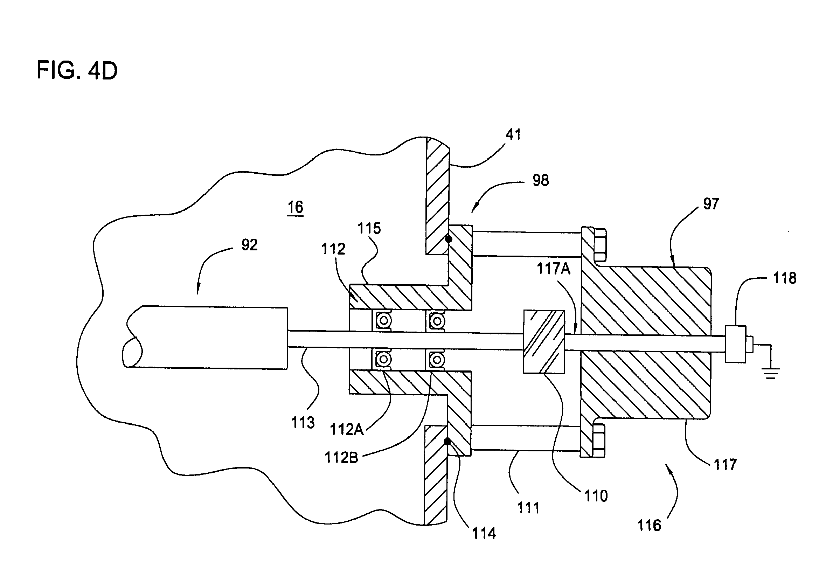

In one aspect, the feed roller assembly 96 and take-up roller assembly 95 both generally contain a motion control assembly 116 (Figures 4A-C discussed below), a spindle 92, a sealing assembly 98 (see elements 98A-B in Figures 4A-B and 98 in Figure 4D) and rotation assembly 97 (see elements 97A-B in Figures 4A-B and 97 in Figure 4D), which are adapted to control the tension on the conductive member(s) 91 and the process of moving or positioning the conductive member 91 in the processing region 15.

In one embodiment, the controller 101 may be adapted to continually adjust the position of the conductive member 91 during processing to reduce the possibility of the deposited film from affecting the deposition uniformity on the substrate 12 or particle performance of the PVD process. In another aspect, the conductive member 91 remains stationary during processing and is repositioned after every substrate deposition process. In another aspect, the conductive member 91 is repositioned after multiple deposition processes have been performed on a region of the conductive member 91 found in the processing region 15. To perform the task of controlling the position of the conductive member 91, the feed roller assembly 96 and the take-up roller assembly 95 each contain the motion control assembly 116, which may have a rotational position tracking device, such as an encoder, that can be used in combination with the controller 101 to control the position, speed and tension of the conductive member 91 as it passes through the processing region 15.

In one aspect, the take-up roller assembly 95 contains a motion control assembly 116 and the feed roller assembly 96 is spring loaded (e.g., torsional spring). In this configuration the feed roller assembly 96 is adapted to keep the conductive member 91 under tension, but allows the take-up roller assembly 95 to control the position and feed rate of the conductive member 91 in the processing region 15.

Figure 3C, which is similar to Figure 3B, is intended to illustrate one issue caused by the position of the anode surface(s), in this case the conductive member 91, in the processing region 15. In one case if the conductive member 91 is too close to the substrate 12 the conductive member 91 can tend to shadow the surface of the substrate from the material sputtered from the surface of the target, thus causing a depression 11C in the film 11A formed on the surface of the substrate 12. Since this problem can cause non-uniformity related defects in the film 11A, the position of the conductive member 91 relative to the substrate surface may be optimized to reduce its shadowing effect. The optimum distance of the conductive member 91 to the surface of the substrate 12 may vary depending on the gas pressure in the processing region 15, the sputtering process power and the distance between the substrate 12 and the target surface 24C. In general the conductive member may be placed about half way between the target and the substrate. For example, where the substrate to target spacing is 200mm, the conductive member may be placed at a distance of about 100mm from the target. In one aspect, the conductive members 91 are placed a fixed distance between about 70 mm and about 130 mm from the target surface 24C.

Referring to Figure 3D, in one aspect, the shape of the conductive member 91 may be varied to reduce the conductive member 91's shadowing effect on the surface of the substrate 12. Figure 3D illustrates one embodiment of a conductive member 91 that has an oval cross-section to reduce the shadowing effect of the conductive member 91 on the deposited film 11A on the surface of the substrate 12. The rounded ends of the oval may be useful to prevent flaking of the film 11 B deposited on the conductive member 91, due tensile or compressive stresses formed in the deposited film. In other aspects of the invention, the cross-section of the conductive member 91 may be formed to increase the surface area of the anode surfaces and/or reduce the shadowing effect of the conductive member 91.

Even though, Figures 3A-D illustrate circular and oval cross-sections of the conductive member 91, in other embodiments of the invention, the conductive member 91 may have a cross-section that are square, rectangular, triangular, star shaped, or other useful geometric shape without varying from the basic scope of the invention. In one aspect of the in, the cross-section of the conductive member is circular and has a diameter between about 0.5 mm and about 12.0 mm.

Figure 4A illustrates a top cross-sectional view of one embodiment of the processing chamber 10, where the cross-sectional plane is positioned in the processing region 15, below the target 24 but above the conductive members 91. Figure 4A illustrates one embodiment having three conductive members 91 that pass though the processing region 15. In one aspect, the number of conductive members passing through the processing region 15 may be between about 1 and about 130 depending on the desired process uniformity, cost and complexity allowed for a desired application. Preferably, the number of conductive members 91 that pass through the processing region 15 is between about 2 and about 10 conductive members.

It should be noted that the cross-sectional area and the material used to form the conductive member 91 may important since it will affect the conductive member's ability to withstand the high temperatures that it will be seen during processing (e.g., resistive heating and interaction with the plasma). The number of conductive members 91 and their surface area exposed in the processing region 15, or total surface area of the adjustable anode assembly 90, may also be important since it will have an effect amount of amount of current carried by each conductive member 91 and thus the maximum temperature achieved by each conductive member 91 during processing. The total surface area of the adjustable anode assembly 90 can be defined by the length of the conductive member 91 in the processing region times the length of the perimeter around the cross section of the conductive member times the number of conductive members positioned in the processing region. Since the length of the conductive members may vary as the substrates size varies it is often useful to describe a parameter known as the "unit surface area" for each conductive member, which is the length of the perimeter of the cross-section of each conductive member 91 per unit length. For example, for a 5.0 mm diameter circular conductive member the unit surface area is about 15.708 mm²/mm (e.g., π x D/1 mm) and thus for a single 2000 mm long conductive member the surface area will be about 31,416 mm². Therefore, for a process chamber 10 that has three conductive members that are 5.0 mm in diameter that are all 2000 mm long the total conductive member 91 surface area would be about 94,248 mm². In one aspect of the invention, the unit surface area of each of the conductive members 91 is between about 1.5 mm²/mm and about 75 mm²/mm. In one aspect, the cross-sectional area of the conductive member 91 may vary between about 0.2 mm² and about 125 mm². In one example, for a substrate that is 1800 mm x 1500 mm in size the surface area of the conductive members 91 can be about 6.0 m². In one aspect, the cross-sectional area of the conductive members 91 is sized to carry the current delivered to the conductive members 91 from the plasma generated by the target bias. In one example, the total current that may be carried by all of the conductive members is about 1000 amps.

In the configuration shown in Figure 4A the conductive members 91 are wound around the spindle 92 contained in a single take-up roller assembly 95 and a single feed roller assembly 96. The conductive members 91 are thus fed from the feed roller assembly 96 through the first slots 50B formed in the shield 50, pass over the substrate 12 positioned on a substrate support 61 (not shown), and then exit the process region 15 through the second slots 50C formed in the shield 50 where they are received by the take-up roller assembly 95. In general the take-up roller assembly 95 and feed roller assembly 96 are positioned in the lower vacuum region 16 to prevent material from being deposited on them during processing, which can affect the reliability and the particle performance of the processing chamber 10. The first slot 50B and second slot 50C are generally sized to prevent plasma leakage from the processing region 15 and sputtered material from depositing on components retained in the lower vacuum region 16. In one aspect of the invention the aspect ratio (*i.e.,* diameter and/or length) of the slots 50B and 50C formed in the shield 50 are sized to prevent leakage of the plasma and deposited material. In another aspect the slots 50B and 50C have shielding features (not shown) which create a circuitous path in which the sputtered material must pass-through to make its way out of the processing region 15.

Figure 4B illustrates a top cross-sectional view of the processing chamber 10 similar to the view shown in Figure 4A, which has a conductive member 91 that has additional cross-members 91 B to increase the surface area of the adjustable anode assembly 90. In this way the conductive member 91 could be a wire mesh that contains a desired pitch of conductive members 91A and cross-members 91 B to increase the surface area of the adjustable anode assembly 90. In this configuration, the conductive member 91A and cross-members 91 B can be delivered to and from the processing region 15 through a slots 50D formed in the shield 50. In one aspect, the conductive member 91, which has elements 91A and 91B, is wound around the spindles 92 found in the feed roller assembly 96 and take-up roller assembly 95. This configuration may be advantageous to reduce any potential difference between the various discrete conductive members 91 passing though the processing region 15, which may improve the plasma density uniformity and thus deposition uniformity.

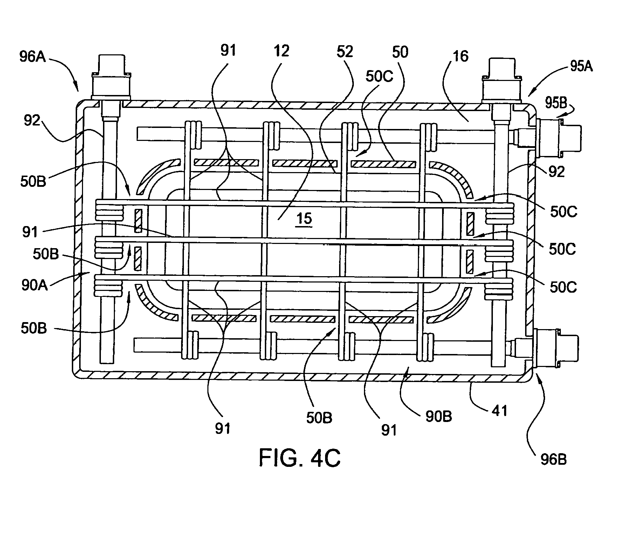

In one aspect, illustrated in Figure 4C, two sets of adjustable anode assemblies 90 (elements 90A and 90B) are oriented so that the conductive members 91 in each of the adjustable anode assemblies 90 are oriented at some angular relationship to each other and where one set of conductive members 91 are at different distances from the target surface 24C to prevent interference between the conductive members 91 in the different adjustable anode assemblies. For example, three conductive members 91 in a first adjustable anode assembly 90A may be oriented in a first direction and positioned a first distance from the target, while a second adjustable anode assemblies 90B having four conductive members 91 is positioned in second direction which is orthogonal to the first direction and is spaced a second distance from the target which is larger than the first distance. In one aspect, the two sets of adjustable anode assemblies 90 (elements 90A and 90B) contain take-up roller assemblies 95 (elements 95A-B), feed roller assemblies 96 (elements 96A-B) and conductive members 91. In this way the anode area can be more evenly distributed throughout the processing region 15, which can be important when using large area substrates that are rectangular in shape. In one aspect the potential difference of each of the adjustable anode assemblies 90 (elements 90A and 90B) can be varied by adjusting the electrical characteristics (e.g., resistance) of their path(s) to ground, which may be useful for tuning the process uniformity.

Figure 4D illustrates a cross-sectional view of one embodiment of a motion control assembly 116 that is adapted to rotate the spindle 92 and thus adjust the position, tension and speed of the conductive member 91 as it passes through the processing region 15. In general the motion control assembly 116 contains a seal assembly 98 and a motor assembly 97. The seal assembly 98 generally contains a shaft 113 coupled to the motion assembly 97 and the spindle 92, a mounting plate 115 and at least one seal 112. In this configuration the rotational motion of the motor assembly 97 is translated to the spindle 92 and is passed from atmospheric pressure outside the chamber wall 41 to a vacuum pressure inside the lower vacuum region 16 where it connects to the spindle 92. In one aspect, as shown in Figure 4D, the seal 112 are two lip seals (elements 112A and 112B) that are adapted to allow rotation of the shaft 113 and prevent leakage of atmospheric contaminants into the processing chamber. In one aspect it may be necessary to differentially pump (not shown) the region between the two seals to reduce the pressure drop across a single seal (elements 112A or 112B). In one aspect of the invention the seal 112 is a conventional ferrofluidic seal (e.g., purchased from Schoonover, Inc. of Canton, Georgia) or magnetically coupled rotational feedthrough which are well known in the art for passing rotational motion to a part in a vacuum environment. Therefore, by use of the seal 112 and a o-ring seal 114 formed between the plate 115 and the chamber wall 41 the atmospheric contaminants can be kept from the lower vacuum region 16 and the processing region 15.

The actuator assembly 97 generally contains an actuator 117, a mounting bracket 111 that is used to attach the motor to the seal assembly 98, and a motor coupling 110 that attached the actuator 117 to the shaft 113. In one aspect the output shaft of the actuator 117 is coupled to the shaft 113 through a tension retaining device, such as a torsional spring (not shown), so that a consistent force and tension can be applied to the conductive member 91 held on the spindle 92 of both the take-up roller assembly 95 and the feed roller assembly 96. In one aspect, a rotating electric feed-through 118, such as a slip ring or rotating mercury feed-through, is electrically connected to the spindle 92 to allow current to flow from the conductive member 91, through the spindle 92, the shaft 113, the motor shaft 117A and the rotary electric feed-through 118 to a ground connection. In one aspect, the actuator 117 may be a DC servo motor or stepper motor, which are well known in the art.

### Magnetron Design For Processing

Figure 5A illustrates one embodiment of the present invention showing close up of the target surface 24C and a plurality of magnetron assemblies 23 (e.g., three shown). In this configuration of the processing chamber 10 multiple magnetron assemblies 23 (elements 23A-B) that contain one or more magnets 27. Typically to improve utilization of the target material and improve deposition uniformity it is common to translate, scan, and/or rotate the magnetron assemblies in a direction that is parallel to the target surface 24C by use of a magnetron actuator (not shown). In general, during PVD deposition processing a large portion of the generated plasma in the processing region 15 is formed and is retained below the magnetron assemblies 23 due to the magnetic fields (elements "B") containment of the electrons found in the processing region 15. The magnetron assembly 23 thus has an effect on the shape and uniformity of the PVD deposited layer due to the strength and orientation of the magnetic fields generated by the magnetron assembly 23.

In one embodiment of the processing chamber 10, the magnetron design may be arranged so that the magnetron assemblies 23 have a higher generated magnetic field strength in the center of the target than at the edge of the target in an effort to balance out the difference in the resistance of the preferential path to ground at the edge of the target 24 versus the center of the target 24. In another aspect, a higher magnetic field strength per unit time is maintained over the center of the target by adjusting the translation, scanning or rotation speed off the magnets across the surface of the target by their actual position relative to the target edge (e.g., slower velocity at the center and higher velocity at the edge). A stronger magnetic field can be created by using stronger magnets near the center of the magnetron, increasing the density of magnets in the center versus the edge of the magnetron, positioning additional stronger stationary magnets over the center of the target and or increasing the movement dwell time over the center to the target as the magnetron is translated across the back of the target. Figure 5A illustrates three magnetrons positioned at the center (element 23A) and at the edge (elements 23B) of the target 24. A translation mechanism used to move the magnetron, along with magnet orientations in the magnetron assembly, that may be adapted to benefit the invention described herein is further described in the commonly assigned United States Patent Application serial number 10/863,152 [AMAT 8841], filed June 7th, 2004, which claims the benefit of United States Provisional Patent Application serial number 60/534,952, filed January 7th, 2004, and is hereby incorporated by reference in its entirety to the extent not inconsistent with the claimed invention. It should be noted that the optimum magnetic field profile for a processing chamber 10 will vary from one substrate size to another, from the ratio of the anode (e.g., grounded surface) to cathode (e.g., target) area, target to substrate spacing, process pressure, motion of the magnetron across the target face, deposition rate, and type of material that is being deposited.

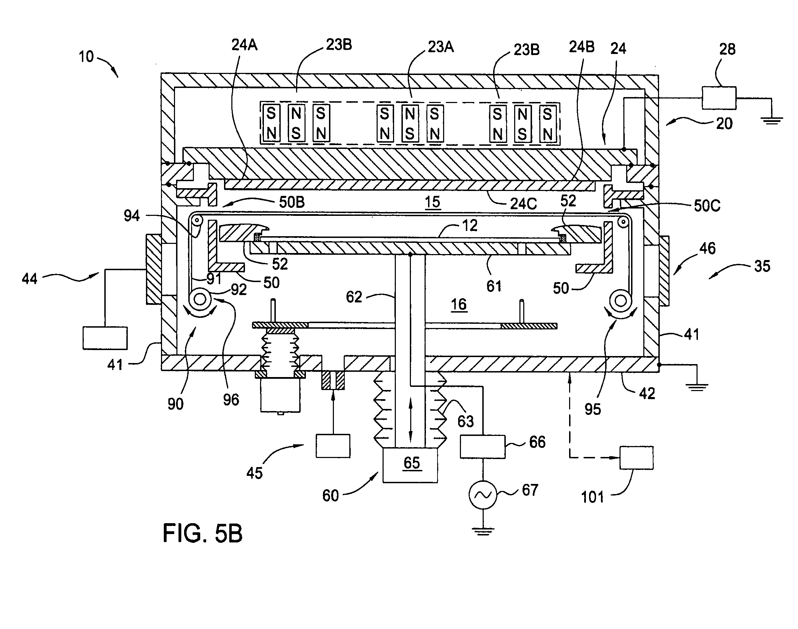

However, by orienting the magnetron shape, magnetic field density and scanning profile across the target a more uniform deposition profile can be achieved on a large area substrate. Figure 5B illustrates one embodiment of the processing chamber 10 illustrates in Figure 2A that has a magnetron assembly which has multiple magnetron assemblies 23 (elements 23A-B) to optimize the magnetic field density created across the surface of the target 24.

The effectiveness of the magnetron 23 on reducing the center to edge deposited thickness variation is affected by the magnetic permeability of the target material(s). Therefore, in some case the magnetron magnetic field pattern may need to be adjusted based on the type of target 24 material(s) and their thickness(es). Also, in some cases the effectiveness of the optimized magnetron magnetic fields to control the center to edge is limited and thus the use of one or more adjustable anode assemblies 90 and/or making electrical contact with the deposited layer embodiment (discussed below) need to be combined to achieve a desired process uniformity.

### Electrical Contact to The Deposited Layer

Figures 6A-C illustrates one embodiment of the processing chamber 10 in which a shadow frame 52, which has been connected to ground, is adapted to make contact with the deposited layer 11 on the substrate 12, so that the deposited layer 11 will act as an anode surface. This configuration thus increases the anode surface area during processing by using the deposited layer 11 as an anode surface to improve the uniformity of the plasma in the processing region. Figure 6A illustrates one embodiment in which a conductive feature 52A is used to make contact with the deposited layer 11 found on a substrate 12 positioned on a substrate support 61, when the support 61 and substrate 12 are brought into contact with the shadow frame 52 that is grounded. In one aspect, the shadow frame 52 is directly connected to the shield 50 by use of conductive strap or wire (element 52D in Figure 6A). In one aspect, the adjustable anode assembly 90 and a process shield 50 that has a first slot 50B and second slot 50C, have been optionally added to the process chamber 10 (illustrated in Figure 5A) to further increase the anode surface area. The process chamber 10 shown in Figures 6A-C are similar to the chamber shown in Figure 2A, therefore, like element numbers have been carried over for clarity.

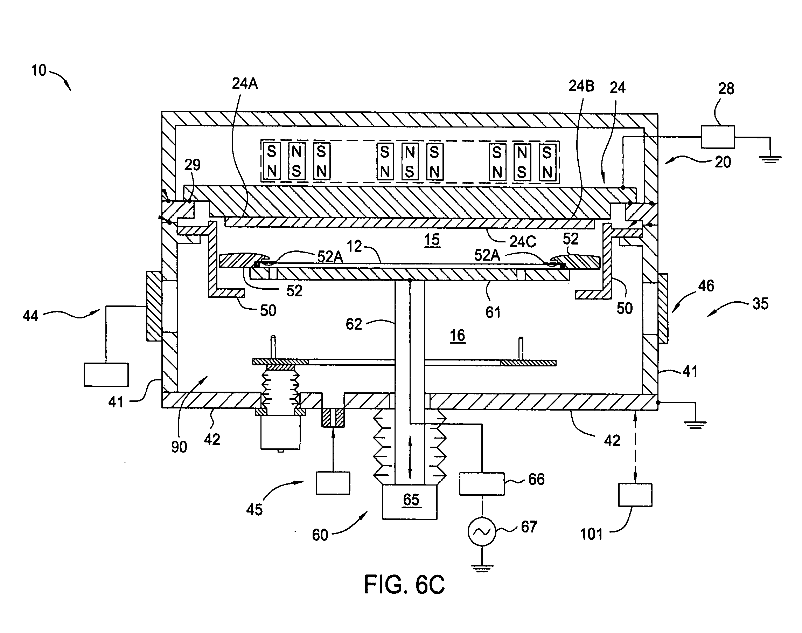

In one embodiment, a conductive feature 52A is attached to a surface of the shadow frame 52 and is held in place by use of block 52B. In one aspect, the block 52B clamps the conductive feature 52A to the underside of the shadow frame by use of a plurality of screws or fasteners (not shown) so that the conductive feature 52A is in electrical contact with the shadow frame 52. In Figures 6A-B the conductive feature 52A is shown in its uncompressed state which occurs when the substrate surface is not in contact with the conductive feature 52A. In Figure 6C the conductive feature 52A is illustrated in its compressed state so that it can make electrical contact with the film 11 deposited on the surface of the substrate 12. In general, the conductive feature 52A may be made from a thin sheet, foil, or rod of conductive material that is adapted to transfer the current transferred to the conductive film 11 (Figure 6A) from the generated plasma. In one aspect, the encroachment of the conductive feature 52A onto the substrate surface is physically minimized to reduce the amounted of wasted area on the edge of the substrate. In one aspect, the conductive feature 52A may be made from a metal, such as, for example, titanium, stainless steel, copper, platinum, gold, brass, hastelloy C, or other material that may be used to form electrical contacts.

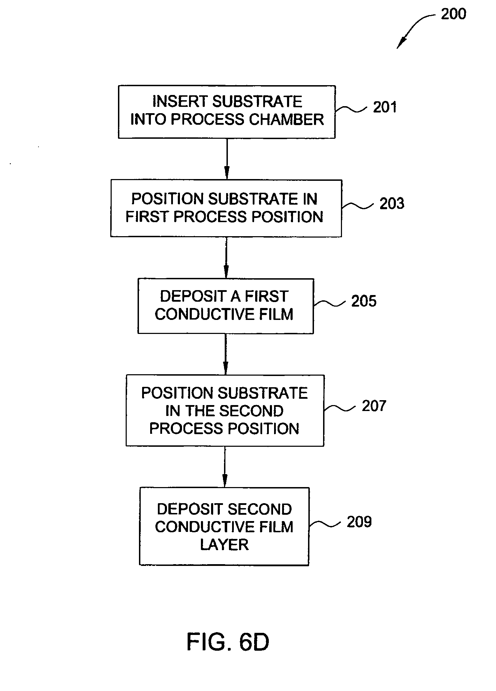

Figure 6D illustrates one embodiment of a series of method steps 200 that may be used to improve the deposition uniformity by making electrical contact with a conductive layer 11 (Figure 6A) formed on a substrate surface. The deposition process may generally contain the following steps: an insert substrate into process chamber step 201, a position substrate in first process position step 203, a deposit a first conductive film step 205, a position substrate in the second process position step 207, and a deposit a conductive film step 209. In other embodiments, the sequence of the method steps 200 may be rearranged, altered, one or more steps may be removed, or two or more steps may be combined into a single step without varying from the basic scope of the invention.

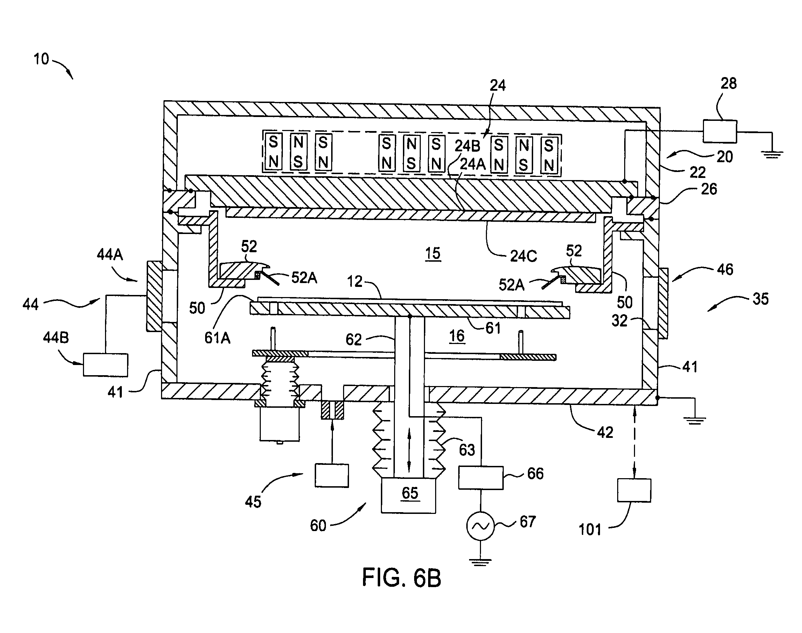

Referring to Figures 6B and 6D, the insert substrate into process chamber step 201 is completed when the controller 101 commands the vacuum pumping system 44 to evacuate the processing chamber 10 to a predetermined pressure/vacuum so that the plasma processing chamber 10 can receive a substrate 12 from a system robot (not shown) mounted to a central transfer chamber (not shown) which typically also under vacuum. To transfer a substrate 12 to the process chamber the slit valve (element 46), which seals off the processing chamber 10 from the central transfer chamber, opens to allow the system robot to extend through the access port 32 in the chamber wall 41. The lift pins 74 then remove the substrate 12 from the extended system robot, by lifting the substrate from the extended robot blade (not shown). The system robot then retracts from the processing chamber 10 and the slit valve 46 closes to isolate the processing chamber 10 from the central transfer chamber. The substrate support 61 then lifts the substrate 12 from the lift pins 74 and moves the substrate 12 to a desired position.

In step 203, or the position substrate in a first process position step 203, the substrate support 61, which the substrate 12 is positioned on, is moved to a desired first processing position below the target 24. In this case the first processing position (see Figure 6B) is a position in which the substrate is placed in close proximity to the grounded shadow frame 52 to shadow the film deposited in the next method step 205 from coating the bevel region (element 12B in Figure 6A) and backside (element 12C in Figure 6A) of the substrate and the exposed substrate support surface 61A. The first process position is also a position where the grounded shadow frame 52 is positioned above, but not in electrical contact with the surface of the substrate.

The deposit a first conductive film step 205 includes the process step of depositing a conductive layer on the surface of the substrate that is placed in the first process position (step 203). In one aspect, the deposition process requires the sputtering of a conductive layer on the surface of the substrate that is sufficiently thick enough to form a continuous layer that can transfer enough current to the grounded support frame during the final deposition step (e.g., step 209) to cause the generated plasma to more uniformly form in the processing region 15. In one aspect, the conductive film may be between about 10 Angstroms (Å) and about 1000 Angstroms (Å). In one example, a molybdenum deposition process was performed at a deposition power of about 200 kW and a process pressure of about 2.5 millitorr (mT) for about 10 seconds to achieve a film thickness of about 383 Angstroms (Å). The thickness of the first conductive layer required to promote uniform plasma generation may vary due to the conductivity of the deposited film. Typical films that may be deposited in this step include, but are not limited to, copper, aluminum, aluminum-copper alloys, aluminum neodymium alloys, tantalum, tantalum nitride, tungsten, cobalt, ruthenium, gold, titanium, titanium nitride, molybdenum, and other combinations and alloys thereof.

In step 207, or the position substrate in a second process position step 207, the substrate support 61, which the substrate 12 is positioned on, is moved to a desired second processing position below the target surface 24C (Figure 6C). In this case the second processing position is a position in which the substrate support 61 engages the grounded shadow frame 52 and the substrate 12 is placed in contact with the grounded shadow frame 52. The second process position is a position where the film deposited during the final deposition step (e.g., step 209) is uniformly deposited on the surface of the substrate 12. The actually second process position will vary depending on the process parameters used during the deposition process, which generally include the substrate to target spacing, the deposition process pressure, the deposition process power setting(s), and the magnetron type and movement during processing.

The final step, or the deposit second conductive film layer step 209, is used to deposit a second conductive layer on the substrate surface to achieve a desired film thickness. In one example, the molybdenum deposition process was performed at a deposition power of about 200 kW and a process pressure of about 2.5 mT for about 60 seconds to achieve a film thickness of about 2,300 Angstroms (Å). The second conductive film layer need not be exactly the same as the first conductive film layer and thus may be formed using, or not using, a reactive sputtering process (e.g., TaN, TiN) which are well known in the art. After the step 209 has been completed then typically the substrate will be removed from the processing chamber by following step 201 in reverse.

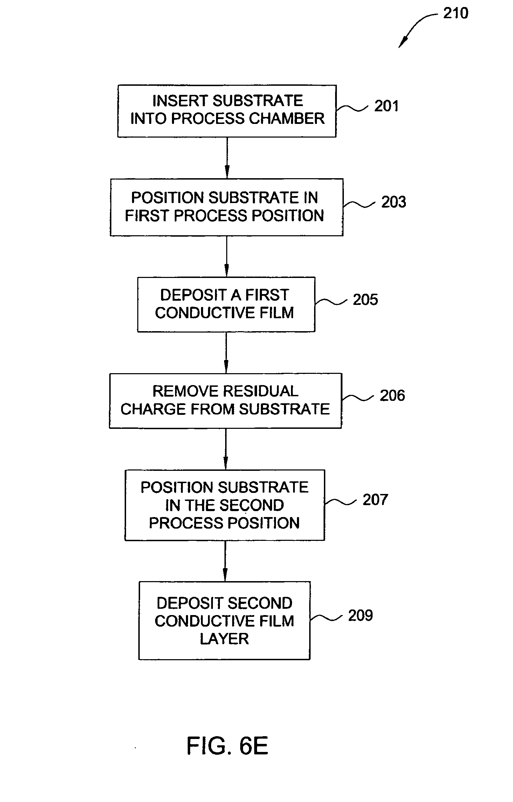

Figure 6E illustrates one embodiment of a series of method steps 210 that may be used to improve the deposition uniformity by making electrical contact with a conductive layer 11 (Figure 6A) formed on a substrate surface. The deposition process illustrated in Figure 6E is the same as the method steps shown in Figure 6D, except that an additional step 206 has been added. In other embodiments, the sequence of the method steps 201 may be rearranged, altered, one or more steps may be removed, or two or more steps may be combined into a single step without varying from the basic scope of the invention.

The method step 206, or remove residual charge from the substrate step 206, is a step that is used to discharge any residual charge residing in the substrate to prevent arcing when the substrate is placed in contact with the grounded shadow frame 52. The residual charge can be formed in a substrate that is electrically floating during plasma processing or some other charge generating process. The retained charge can be formed in the substrate 12 (or floating substrate support 61), due to the interaction of the substrate surface (or floating substrate support 61) with the plasma formed during the deposit a first conductive film step 205, or other prior processing steps. The rapid discharge of the trapped charge can cause arcing and damage to the devices formed on the substrate surface. Therefore, to prevent device damage the remove residual charge step 206 has been added to the method steps described in Figure 6D. In general, the remove residual charge in substrate step 206 is performed by reducing the potential difference between the grounded shadow frame 52 and the substrate 12 prior to them making electrical contact, between the shadow frame 52 and the film 11 formed on the surface of the substrate.

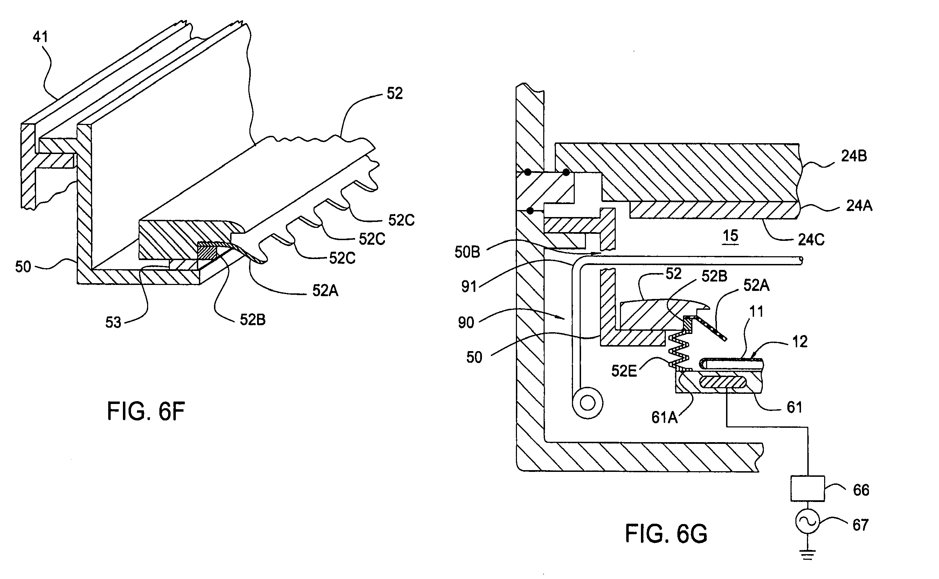

In one aspect, to reduce the potential difference the grounded shadow frame 52 and the substrate support are designed to cause the grounded shadow frame 52 to come into electrical contact with the substrate support 61 prior to the grounded shadow frame 52 electrically contacting the film 11 formed on the substrate 12 (Figure 6G). By causing the shadow frame 52 to contact the substrate support 61 before the substrate 12, any residual charge in the substrate support 61 can be dissipated to prevent arcing through the substrate 12. To perform this task, the grounded shadow frame 52 or substrate support 61, may contain a conductive spring 52E (Figure 6G) to allow the grounded shadow frame 52 to contact the exposed substrate support surface 61A of the substrate support 61 prior to the grounded shadow frame 52 from contacting the substrate 12.

In another aspect, the step 206 may be performed by isolating the shadow frame 52 from ground and then causing the shadow frame 52 to come into electrical contact with a substrate support 61 that has a grounded surface that can electrically contact the shadow frame 52 prior to the shadow frame 52 electrically contacting the film 11 formed on the substrate 12. The shadow frame 52 can be isolated from the anode surfaces (e.g., shield 50) by physically preventing contact between the two components. In one aspect, an insulator 53 (see Figure 6F) may be used to insolate the shadow frame 52 from the shield 50. By causing the shadow frame 52 to come in contact the substrate support 61 before the substrate 12, allows any residual charge in the substrate support 61 to discharge to prevent arcing through the substrate 12. To perform this task, a conductive spring 52C (Figure 6G), described above, may be used to perform this task.

In yet another aspect, the remove residual charge from the substrate step 206 may be performed by isolating the shadow frame 52 from ground (i.e., it electrically "floats") and then electrically coupling the shadow frame 52 to the substrate support 61 and substrate 12, prior to the shadow frame 52 electrically contacting the film 11 formed on the substrate 12. In one aspect, to perform this step the substrate support 61 is RF biased before the floating shadow frame 52 contacts the film 11 formed on the surface of the substrate 12. In this configuration the substrate support 61 may contain biasable elements (element 61 B Figure 6A) that can be used to capacitively RF couple the floating shadow frame 52 and the substrate 12 and substrate support 61 using the an RF power source 67 and RF matching device 66 (shown In Figures 6A) connected to the biasable elements. By use of the RF generated plasma formed by the RF bias of the substrate support 61 the floating shadow frame 52 and substrate 12 can be brought to the same potential prior to them making contact to each other in step 207. In one aspect, the RF bias may be between about 100 watts to about 6000 watts at an RF frequency of 13.56 MHz and a chamber pressure between about 1.0 mT and about 6.0 mT in an argon rich environment is applied to the substrate prior to and during the performance of step 207.

Figure 6F is an isometric cross-sectional view of one embodiment of a shadow frame 52 that has a conductive feature 52A mounted on to its underside. In this configuration the conductive member 52A contains a plurality of conductive fingers 52C formed in the conductive member 52 to allow for repeatable and uniform contact of the conductive film 11 formed on the surface of the substrate 12. In one aspect, the conductive fingers 52C may be a part of a single continuous piece which makes contact all the way around the substrate 12. In another aspect, a plurality of discrete sections of the conductive feature 52A may be placed around the underside of the shadow frame 52 and thus a single monolithic piece of material is not needed to form the conductive feature 52A.

While the foregoing is directed to embodiments of the present invention, other and further embodiments of the invention may be devised without departing from the basic scope thereof, and the scope thereof is determined by the claims that follow.

## Claims

1. A plasma processing chamber assembly for depositing a layer on a substrate (12) comprising:
a plasma processing chamber (10) having a processing region (15);
a target (24) positioned on the plasma processing chamber (10) so that a surface (24C) of the target is in contact with the processing region;
a first anodic member (50) positioned inside the plasma processing chamber (10), wherein the first anodic member is a shield (50) and a surface of the first anodic member is in contact with the processing region (15);
a substrate support (61) positioned inside the plasma processing chamber (10) and having a substrate receiving surface, wherein a surface of a substrate positioned on the substrate receiving surface is in contact with the processing region (15); and
a second anodic member having a first surface positioned inside the processing region and a second surface positioned outside the processing region, wherein the first surface can be removed from the processing region and the second surface can be positioned inside the processing region (15) by use of an actuator (71; 117).

2. The plasma processing chamber assembly of claim 1, wherein the surface area of the surface of the substrate that is in contact with the processing region is at least 19,500 mm².

3. The plasma processing chamber assembly of claim 1 or 2, further comprises:
a feed roller assembly (96) positioned outside of the processing region (15) and connected to the second anodic member; and
a take-up roller assembly (96A, 96B) positioned outside of the processing region (15) and connected to the second anodic member.

4. The plasma processing chamber assembly according to any one of the claims 1 to 3, wherein the second anodic member is a wire, multi-stranded cable, metal ribbon, sheet, or wire mesh.

5. The plasma processing chamber assembly according to any one of the claims 1 to 4, wherein the second anodic member is made of metal selected from a group consisting of titanium, aluminum, platinum, gold, silver, copper, magnesium, manganese, stainless steels, hastelloy C, nickel, tungsten, tantalum, iridium, or ruthenium.

6. The plasma processing chamber assembly according to any one of the claims 1 to 5, wherein the cross-section of the second anodic member is an oval, elliptical, circular, square, rectangular, star or triangular shaped.

7. The plasma processing chamber assembly according to any one of the claims 1 to 6, further comprising a magnetron assembly positioned generally adjacent to a surface of the target, wherein the magnetron assembly is adapted to have a stronger magnetic field strength near the center of the target versus the edge of the target.

8. A plasma processing chamber assembly for depositing a layer on a substrate comprising:
a plasma processing chamber (10) having a processing region (15);
a target (24) positioned on the plasma processing chamber (10) so that a surface (24C) of the target is in contact with the processing region (15);
a first anodic member (50) positioned inside the plasma processing chamber (10), wherein the first anodic member comprises:
one or more walls that surround the processing region;
a first slot (50B) formed through the one of the one or more walls; and
a second slot (50C) formed through the one of the one or more walls;
a substrate support (61) positioned inside the plasma processing chamber and having a substrate receiving surface, wherein a surface of a substrate positioned on the substrate receiving surface is in contact with the processing region; and
one or more adjustable anode assemblies (90; 90A; 90B) that comprise:
a second anodic member (90) extending through the first slot and the second slot, and having a surface that is in contact with the processing region;
a feed roller assembly (96) positioned outside of the processing region and connected to the second anodic member; and
a take-up roller assembly (96A; 96B) positioned outside of the processing region and connected to the second anodic member (90), wherein the feed roller assembly (96) and the take-up roller assembly (96A; 96B) are adapted to cooperatively adjust the position of the surface of the second anodic member (90) in the processing region.

9. The plasma processing chamber assembly of claim 8, wherein the second anodic member (90) is a wire, multi-stranded cable, metal ribbon, sheet, or wire mesh.

10. The plasma processing chamber assembly of claim 8 or 9, wherein the second anodic member (90) is made of metal selected from a group consisting of titanium, aluminum, platinum, gold, silver, copper, magnesium, manganese, stainless steels, hastelloy C, nickel, tungsten, tantalum, iridium, or ruthenium.

11. The plasma processing chamber assembly of claim 8, 9 or 10, wherein the cross-section of the second anodic member (90) is an oval, elliptical, circular, square, rectangular, star or triangular shaped.

12. A plasma processing chamber assembly for depositing a layer on a substrate comprising:
a plasma processing chamber (10) having a processing region (15);
a target (24) positioned on the plasma processing chamber (10) so that a surface (24C) of the target is in contact with the processing region (15);
an anodic shield (50) positioned inside the plasma processing chamber (10), wherein a surface of the anodic shield (50) is in contact with the processing region (15);
a substrate support (61) having a substrate receiving surface positioned inside the plasma processing chamber (10), wherein a substrate positioned on the substrate receiving surface is in contact with the processing region (15); and
a shadow frame (52) having a surface that is in contact with the processing region (15)and having a conductive feature that is in electrical communication with an anodic shield (50), wherein the conductive feature is adapted to contact a metal layer formed on a substrate that is positioned on the substrate receiving surface.

13. The plasma processing chamber assembly of claim 12, further comprising a second anodic member (90) having a first surface positioned inside the processing region (15) and a second surface positioned outside the processing region (15), wherein the first surface can be removed from the processing region (15) and the second surface can be positioned in the processing region (15).

14. The plasma processing chamber assembly of claim 12 or 13, wherein the surface area of the surface (12) of the substrate that is in contact with the processing region is at least 19,500 mm².

15. The plasma processing chamber assembly of claim 12, 13 or 14, further comprising a second anodic member (90) having a first surface positioned inside the processing region (15) and a second surface positioned outside the processing region (15), wherein the first surface can be removed from the processing region and the second surface can be positioned inside the processing region (15).

16. A method of depositing a thin film on a substrate, comprising:
placing a substrate (12) on a substrate support (61) that is mounted in a processing region (15) of a processing chamber (10);
positioning a substrate (12) in a first processing position (203) in the processing region of a plasma processing chamber;
depositing a layer onto a surface of the substrate positioned on the substrate support;
positioning the substrate in a second processing position in the processing region of a plasma processing chamber, wherein positioning the substrate in a second processing position includes the step of placing a layer deposited on the surface of a substrate in electrical contact with a shadow frame that is in electrical communication with an anode surface in the plasma processing chamber; and
depositing a layer onto the surface of the substrate positioned on the substrate support.

17. A method of depositing a thin film on a surface of a substrate positioned in a processing region of a plasma processing chamber, comprising:
depositing a layer onto a surface of a conductive member and a surface of a substrate positioned on a substrate support;
positioning a surface of the conductive member in the processing region while the plasma processing chamber is at a pressure below atmospheric pressure, wherein the surface of the conductive member was positioned outside of the processing region prior to being positioned inside the processing region.

18. The method of claim 17, wherein the step of positioning a surface of the conductive member is performed while the depositing a layer onto a surface of a conductive member is being performed.

19. A method of depositing a thin film on a substrate, comprising:
depositing a layer onto a first surface of a conductive member and a surface of a first substrate positioned on a substrate support positioned in a processing region of a plasma processing chamber;
removing the first surface of the conductive member from the processing region and positioning a second surface of the conductive member in the processing region by use of one or more actuators, wherein the step of removing the first surface and the step of positioning a second surface is completed while the processing region is at a pressure that is less than atmospheric pressure;
removing the first substrate from the plasma processing chamber; and
depositing a second layer onto the second surface of the conductive member and a surface of a second substrate positioned on the substrate support that is positioned in the processing region of the plasma processing chamber.
